# EUROPEAN PATENT APPLICATION

(11) **EP 4 783 764 A1**
(43) Date of publication of application: **29.07.2026**
(21) Application number: 26153460.6
(22) Date of filing: 22.01.2026
(51) Int. Cl.: H05K 7/20

(54) **SYSTEM AND APPARATUS FOR POWER ELECTRONICS COOLING**

(30) Priority: 27.01.2025 US 202519037510
(71) Applicant: Cummins, Inc., Columbus, Indiana 47201 (US)
(72) Inventor: TENAGLIA, Gabriel, Columbus 47201 (US); KRISHNAMOORTHI, Santhosh, Indianapolis 46237 (US); GIANNINI, Joe, Oakdale 55128 (US); HAYS, Michael, Columbus 47203 (US); ECKROTH, David, Columbus 47203 (US); BELLUR, Dakshina, Plymouth 55446 (US)
(74) Representative: Cleveland Scott York

(57) **Abstract**

A cooling system and apparatus for power electronics includes a first heat sink and a second heat sink with coolant flow paths that receive coolant for cooling different sides of the power electronics. A first connector assembly at the inlet ends of the first and second heat sinks connects the coolant flow paths to a cooling loop, receives the coolant from the cooling loop, and splits the coolant between the coolant flow paths of the first and second heat sinks. A second connector assembly at the outlet ends of the first and second heat sinks collects the coolant flow from the coolant flow paths of the first and second heat sinks and outlets the combined coolant flows to the cooling loop.

## Description

### STATEMENT REGARDING GOVERNMENT RIGHTS

This invention was made with government support under DE-EE0009652 awarded by the Department of Energy. The government has certain rights in this invention.

### Technical Field of the Disclosure:

The present application relates generally to thermal management of power electronics such as those used in conjunction with powertrains, and more particularly to systems and apparatuses for cooling power electronics.

### BACKGROUND

Power electronics such as semi-conductors are employed in powertrains and systems that include electrified components, including electric powertrains, hybrid powertrains, fuel cells, internal combustion engines, and auxiliary power systems, to name a few. The power electronics typically require cooling, which can be provided by circulating cooling fluid near the heat generating power electronic components. The cooling requirements can hinder high density packaging of the power electronic components. The cooling requirements can also require a number of steps in the assembly of the power electronic components and hinder placement of the power electronics within enclosures. Thus, there remains a need for further improvements in this area.

### DISCLOSURE OF ILLUSTRATIVE EMBODIMENTS

For the purposes of clearly, concisely, and exactly describing illustrative embodiments of the present disclosure, the manner, and process of making and using the same, and to enable the practice, making and use of the same, reference will now be made to certain exemplary embodiments, including those illustrated in the figures, and specific language will be used to describe the same. It shall nevertheless be understood that no limitation of the scope of the invention is thereby created and that the invention includes and protects such alterations, modifications, and further applications of the exemplary embodiments as would occur to one skilled in the art.

### SUMMARY

Exemplary embodiments include systems and apparatuses for cooling power electronics associated with powertrains and power systems. For example, an embodiment includes a cooling system for power electronics. The cooling system includes at least one coolant line for circulating a coolant for cooling the power electronics. The cooling system also includes at least one enclosure housing the power electronics and a manifold engaged to the at least one enclosure and to the at least one coolant line. The manifold provides a first flow path and a second flow path for the coolant along opposite sides of the power electronics housed in the at least one enclosure. The manifold includes a first connector assembly mounted to a first side of the at least one enclosure. The first connector assembly includes an inlet fluidly connected to receive the coolant from the at least one coolant line. The first connector assembly includes a splitter connected to the first flow path and to the second flow path within the at least one enclosure. The splitter is configured to split the coolant received by the inlet and direct the split coolant into the first flow path and the second flow path. The manifold also includes a second connector assembly mounted to a second side of the at least one enclosure. The second connector assembly is configured to combine the coolant received from the first flow path and from the second flow path. The second connector assembly includes an outlet fluidly connected to the at least one coolant line.

In another example, an embodiment includes an apparatus for cooling power electronics. The apparatus includes a first heat sink defining a first flow path for a coolant and a second heat sink defining a second flow path for the coolant. The first flow path extends from a first inlet end to a first outlet end of the first heat sink, and the second flow path extends from a second inlet end to a second outlet end of the second heat sink. The second heat sink is spaced from the first heat sink in order to receive power electronics therebetween. The apparatus also includes a first connector assembly connected to the first inlet end of the first heat sink and the second inlet end of the second heat sink. The first connector assembly includes an inlet for receiving the coolant, a first inlet channel aligned with the first flow path of the first heat sink to fluidly connect the inlet to the first flow path, and a second inlet channel separated from the first inlet channel. The second inlet channel is aligned with the second flow path of the second heat sink to fluidly connect the inlet to the second flow path. The apparatus further includes a second connector assembly connected to the first outlet end of the first heat sink and the second outlet end of the second heat sink. The second connector assembly includes a first outlet channel aligned with the first flow path of the first heat sink to receive the coolant from the first flow path and a second outlet channel separated from the first outlet channel. The second outlet channel is aligned with the second flow path of the second heat sink to receive the coolant from the second flow path. The second connector assembly also includes an outlet for receiving the coolant from the first outlet channel and the second outlet channel.

Further embodiments, forms, objects, features, advantages, aspects, and benefits shall become apparent from the following description and drawings.

### BRIEF DESCRIPTION OF THE DRAWINGS

FIG. 1 is a schematic illustration of one embodiment of a system for cooling power electronics according to an embodiment of the present disclosure.
FIG. 2 is a perspective view of an embodiment of a cooling apparatus that can be employed in the system of FIG. 1 with power electronics mounted thereto.
FIG. 3 is another perspective view of the cooling apparatus and power electronics of FIG. 2 with the cooling apparatus in partial section.
FIG. 4 is an exploded perspective view of the cooling apparatus of FIG. 2.
FIG. 5 is an elevation view of the cooling apparatus of FIG. 2.
FIG. 6 is a longitudinal section view of the cooling apparatus of FIG. 2.
FIG. 7 is a top view of the cooling apparatus of FIG. 2.
FIG. 8 is a bottom view of the cooling apparatus of FIG. 2.
FIG. 9 is an end view of the cooling apparatus of FIG. 2.
FIG. 10 is the end view of FIG. 9 without the bulkhead and the seal.
FIG. 11 is the end view of FIG. 10 without the splitter.

### DETAILED DESCRIPTION OF ILLUSTRATIVE EMBODIMENTS

The cooling system and apparatus disclosed herein include arrangements in which multiple sides of power electronics, such as semiconductor devices, can be cooled simultaneously using coolant circulated in a cooling loop. For example, the apparatus can be connected to the cooling loop to receive a coolant flow, distribute the coolant flow along multiple sides of the power electronics, and collect the heated coolant from the multiple sides of the power electronics and return the heated coolant flow to the coolant loop for temperature reduction.

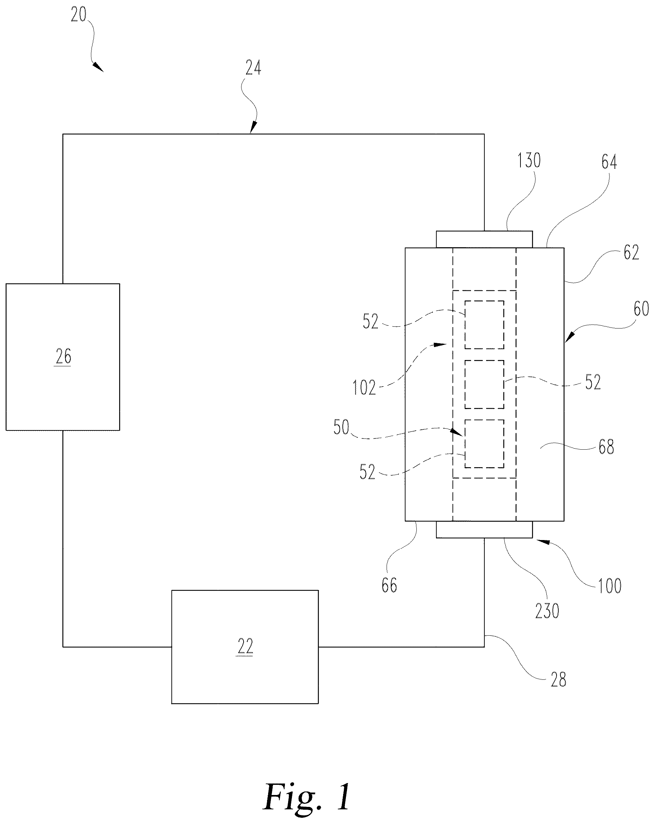

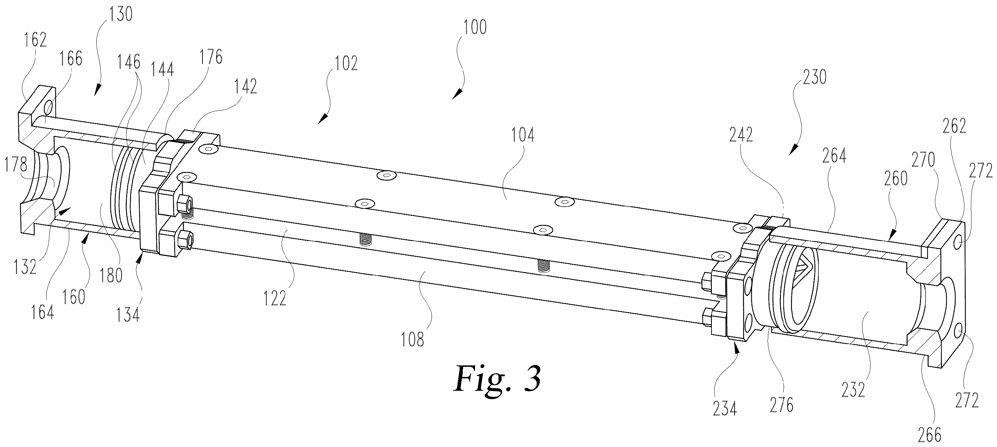

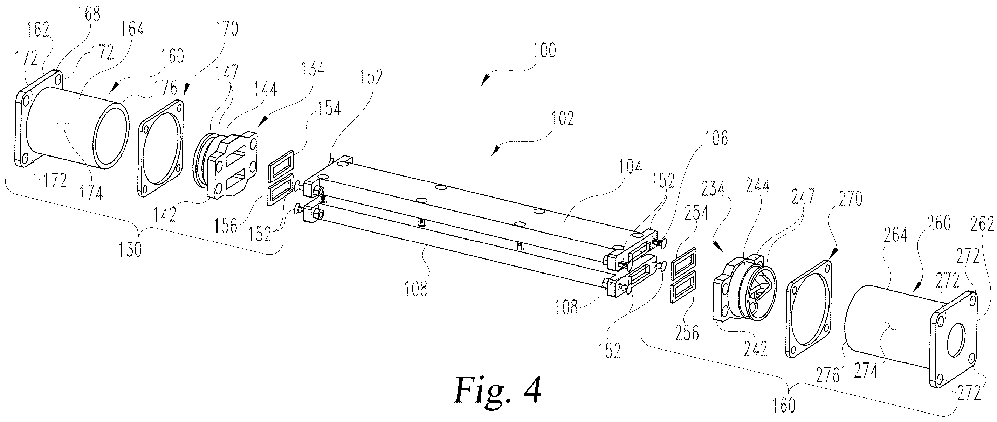

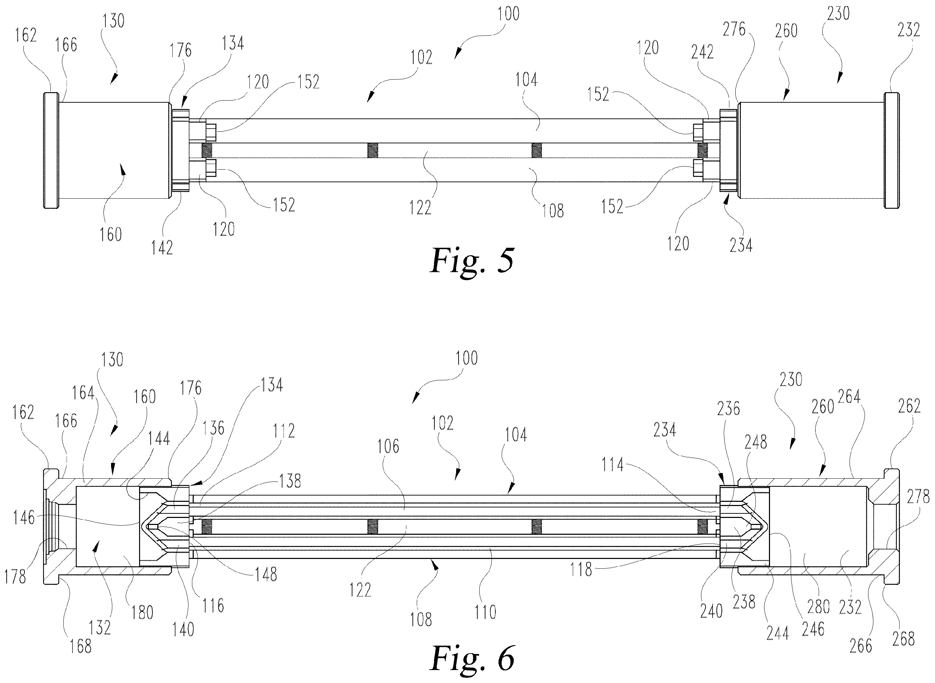

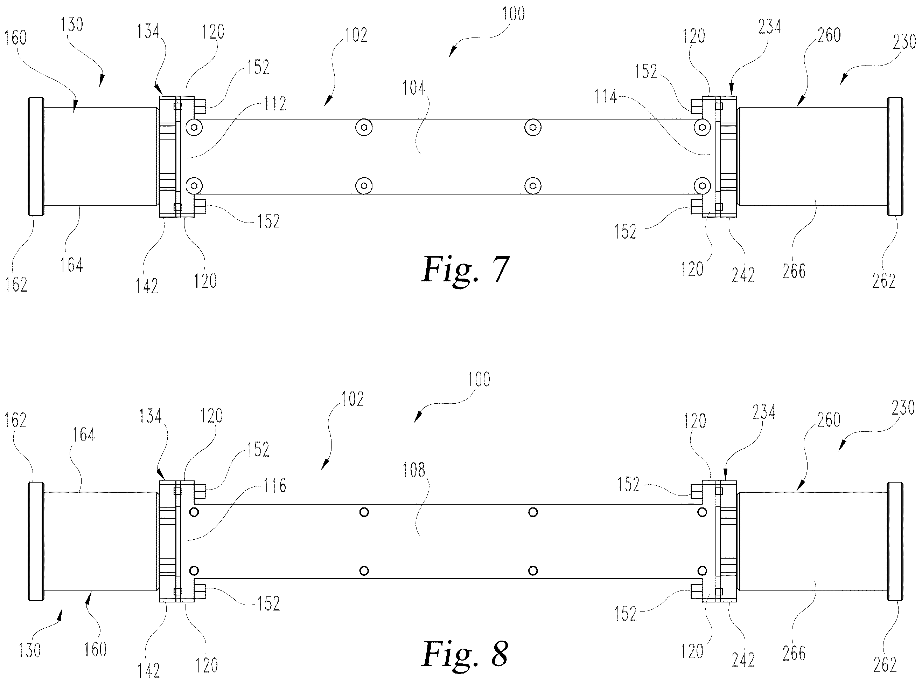

With reference to FIGs. 1-11, a cooling system 20 for power electronics 50 is provided. Cooling system 20 includes at least one coolant line 28 for circulating a coolant for cooling power electronics 50. As used herein, coolant line 28 may be any structure, components, plumbing, tube, or other device or combination of such devices that provides a coolant flow path. Cooling system 20 also includes at least one enclosure 60 housing the power electronics and a manifold 102 engaged to the at least one enclosure 60 and to the at least one coolant line 28.

Manifold 102 provides a first flow path 106 and a second flow path 110 for the coolant along opposite sides of power electronics 50 housed in the at least one enclosure 60. Manifold 102 includes a first connector assembly 130 mounted to a first side 64 of the at least one enclosure 60. First connector assembly 130 includes an inlet 132 fluidly connected to receive the coolant from the at least one coolant line 28. First connector assembly 130 includes a splitter 134 connected to first flow path 106 and to second flow path 110 within the at least one enclosure 60. Splitter 134 is configured to split the coolant received by inlet 132 and direct the split coolant into first flow path 106 and second flow path 110. Manifold 102 also includes a second connector assembly 230 mounted to a second side 66 of the at least one enclosure 60. Second connector assembly 230 is configured to combine the coolant received from first flow path 106 and from second flow path 110. Second connector assembly 230 includes an outlet 232 fluidly connected to the at least one coolant line 28.

In another example, an apparatus 100 for cooling power electronics 50 is provided. Apparatus 100 includes a first heat sink 104 defining first flow path 106 for the coolant and a second heat sink 108 defining second flow path 110 for the coolant. First flow path 106 extends from a first inlet end 112 to a first outlet end 114 of first heat sink 104, and second flow path 110 extends from a second inlet end 116 to a second outlet end 118 of second heat sink 108. Second heat sink 108 is spaced from first heat sink 104 in order to receive power electronics 50 therebetween.

Apparatus 100 also includes first connector assembly 130 connected to first inlet end 112 of first heat sink 104 and second inlet end 116 of second heat sink 108. First connector assembly 130 includes inlet 132 for receiving the coolant, a first inlet channel 136 aligned with first flow path 106 of first heat sink 104 to fluidly connect inlet 132 to first flow path 106, and a second inlet channel 140 separated from first inlet channel 136. Second inlet channel 140 is aligned with second flow path 110 of second heat sink 108 to fluidly connect inlet 132 to second flow path 110. Apparatus 100 further includes second connector assembly 230 connected to first outlet end 114 of first heat sink 104 and second outlet end 118 of second heat sink 108. Second connector assembly 230 includes a first outlet channel 236 aligned with first flow path 106 of first heat sink 104 to receive the coolant from first flow path 106 and a second outlet channel 240 separated from first outlet channel 236. Second outlet channel 240 is aligned with second flow path 110 of second heat sink 108 to receive the coolant from second flow path 110. Second connector assembly 230 also includes outlet 232 for receiving the coolant from first outlet channel 236 and second outlet channel 240.

FIG. 1 provides a schematic depiction an exemplary cooling system 20 including coolant reservoir 22 providing coolant for circulation in coolant loop 24, a heat exchanger 26 for reducing the temperature of the coolant in coolant loop 24, and coolant line 28 for connecting coolant loop 24 to power electronics 50 and to deliver the coolant to cool power electronics 50. Other components and/or configuration for cooling system 20 are also contemplated, including multiple cooling loops, pumps, fans, and other power electronics and/or electrical components to be cooled.

Power electronics 50 may include, for example, one or more semiconductor devices 52 housed within at least one enclosure 60. Housing 62 defines an interior 68 in which the one or more semiconductor devices 52 is received. Cooling apparatus 100 includes a manifold 102 mounted to opposite outer first and second sides 64, 66 of a housing 62 of enclosure 60. Manifold 102 also extends through interior 68 along opposite sides of the semiconductor devices 52 to provide cooling of multiple sides of the semiconductor devices 52.

Manifold 102 is mounted to first side 64 with inlet or first connector assembly 130 to distribute the coolant flow along the opposite sides of the power electronics 50 and then collect the coolant flow at outlet or second connector assembly 230. First connector assembly 130 is connected to coolant line 28 at an upstream side 64 of enclosure 60 via first connector assembly 130 and at a downstream side 66 of enclosure 60 via second connector assembly 230. First and second connector assemblies 130, 230 are connected to coolant line 28 in order to receive a flow of coolant at first connector assembly 130, distribute the flow of coolant along multiple sides of the power electronics 50, collect the heated coolant flow, and to outlet the heated coolant flow back into coolant line 28 for cooling at heat exchanger 26.

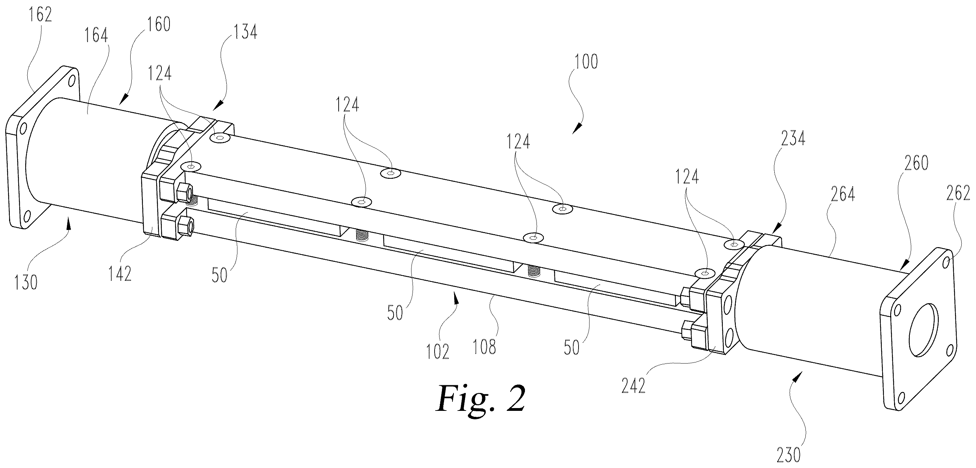

Referring to FIGs. 2-8, first connector assembly 130 includes a first bulkhead 160 coupled to splitter 134. First bulkhead 160 defines inlet 132 extending therethrough to receive the coolant flow from coolant line 28. First bulkhead 160 includes a first mounting flange 162 and a first tubular portion 164 extending from first mounting flange 162. First mounting flange 162 extends outwardly from an outer end 166 of first tubular portion 164 and abuts first side 64 of housing 62 of enclosure 60 while first tubular portion 164 extends through first side 64 into interior 68. First mounting flange 162 includes a plurality of fastener bores 172 to receive fasteners (not shown) such as bolts or screws that secure first connector assembly 130 to housing 62 of enclosure 60.

First connector assembly 130 includes a first face seal 170 that can be positioned against an inner face 168 of first mounting flange 162 to sealingly engage the first side 64 of housing 62. The fasteners in fastener bores 172 can be secured to compress first face seal 170 between first side 64 of housing 62 and first mounting flange 162 of first bulkhead 160. First face seal 170 can prevent migration of air, dust, and other particles into enclosure 60 via the enclosure opening through which first tubular portion 164 extends.

In the illustrated embodiment, first tubular portion 164 includes a cylindrical shape with an outer surface 174 defining a circular cross-section extending from outer end 166 to an opposite inner end 176. Other embodiments contemplate other shapes and configurations for first tubular portion 164, including non-circular shapes. First mounting flange 162 and first tubular portion 164 also define an upstream inlet portion 178 of inlet 132 and a downstream inlet portion 180 downstream of upstream inlet portion 178. Upstream inlet portion 178 is configured to provide a connecting receptacle to connect to coolant line 28 such as via a quick disconnect, threaded connection, snap fit, welded connection, or other suitable connection. Downstream inlet portion 180 receives the coolant flow from the coolant line 28 connected to upstream inlet portion 178.

First tubular portion 164 of first bulkhead 160 is configured to receive a part of splitter 134 therein so that splitter 134 and bulkhead 160 are assembled together in a telescoping manner. In the illustrated embodiment, splitter 134 includes a first end flange 142 that is fastened to first and second heat sinks 104, 108 and a first tubular part 144 extending from first end flange 142 toward bulkhead 160. First tubular part 144 extends from first end flange 142 to an inlet end having a single end opening 146 that receives the coolant flow from inlet 132.

Circular, ring-shaped seals 147 can be provided around first tubular part 144 to sealingly engage an inner surface of first tubular portion 164 to provide a sealed engagement and prevent coolant leakage. First tubular part 144 can be axially adjusted within first tubular portion 164 to adjust the length of first connector assembly 130 and ease assembly of manifold 102 with the enclosure 60.

Splitter 134 includes a partition 138 that separates first inlet channel 136 and second inlet channel 140 at an outlet end of splitter 134. Partition 138 includes a tapered and/or rounded nose 148 facing inlet 132 to divert the coolant flow into respective ones of the first and second inlet channels 136, 140. The tapered and/or rounded configuration of nose 148 can reduce turbulence and assist in evenly dividing the coolant flow to the first and second flow channels 106, 110 of first and second heat sinks 104, 108.

First end flange 142 includes a plurality of fastener holes 150 to receive corresponding ones of the fasteners 152. Fasteners 152 fasten splitter 134 to first inlet end 112 of first heat sink 104 and to second inlet end 116 of second heat sink 108. In an embodiment, first inlet end 112 and second inlet end 116 each include outwardly projecting tabs 120 to receive the fasteners 152 to engage splitter 134 to each of the first and second heat sinks 104, 108. When fastened to heat sinks 104, 108, first inlet channel 136 is aligned with first flow path 106 of first heat sink 104, and second inlet channel 140 is aligned with second flow path 110 of second heat sink 108.

First connector assembly 130 also includes at least one inlet end seal between first end flange 142 and the first and second inlet ends 112, 116 of the first and second heat sinks 104, 108. In an embodiment, a first inlet end seal 154 is sealingly engaged between first end flange 142 of splitter 134 and first inlet end 112 of first heat sink 104. First inlet end seal 154 extends around first flow path 106 of first heat sink 104 at first inlet end 112 and around first inlet channel 136 of first end flange 142. A second inlet end seal 156 is sealingly engaged between first end flange 142 of splitter 134 and second inlet end 116 of second heat sink 108. Second inlet end seal 156 extends around second flow path 110 of second heat sink 108 at second inlet end 116 and around second inlet channel 140 of first end flange 142. In the illustrated embodiments, first and second inlet end seals 154, 156 are rectangular to match the shapes of first and second flow paths 106, 110 and/or first and second inlet channels 136, 140, but other shapes are also contemplated.

Second connector assembly 230 includes a second bulkhead 260 coupled to a combiner 234. Second bulkhead 160 defines outlet 232 extending therethrough to receive the coolant flow from first and second flow paths 106, 110 of first and second heat sinks 104, 108. Second bulkhead 260 includes a second mounting flange 262 and a second tubular portion 264 extending from second mounting flange 262. Second mounting flange 262 extends outwardly from an outer end 266 of second tubular portion 264 and abuts second side 66 of housing 62 of enclosure 60 while second tubular portion 264 extends through second side 66 into interior 68. Second mounting flange 262 includes a plurality of fastener bores 272 to receive fasteners (not shown) such as bolts or screws that secure second connector assembly 230 to enclosure 60.

Second connector assembly 230 includes a second face seal 270 that can be positioned against an inner face 268 of second mounting flange 262 to sealingly engage the second side 66 of housing 62. The fasteners in fastener bores 272 can be secured to compress second face seal 270 between second side 66 and second mounting flange 262. Second face seal 270 can prevent migration of air, dust, and other particles into enclosure 60 via the enclosure opening through which second tubular portion 264 extends.

In the illustrated embodiment, second tubular portion 264 includes a cylindrical shape with an outer surface 274 defining a circular cross-section extending from outer end 266 to an opposite inner end 276. Other embodiments contemplate other shapes and configurations for second tubular portion 264, including non-circular shapes. Second mounting flange 262 and second tubular portion 264 also define a downstream outlet portion 278 of outlet 232 and an upstream outlet portion 280 upstream of downstream outlet portion 278. Downstream outlet portion 278 is configured to provide a connecting receptacle to connect to coolant line 28 such as via a quick disconnect, threaded connection, snap fit, welded connection, or other suitable connection. Upstream outlet portion 280 receives the coolant flow from combiner 234 and combines the coolant flow to outlet to the coolant line 28.

Second tubular portion 264 of second bulkhead 260 is configured to receive a part of combiner 234 therein so that combiner 234 and second bulkhead 260 are assembled together. In the illustrated embodiment, combiner 234 includes a second end flange 242 that is fastened to first and second heat sinks 104, 108 and a second tubular part 244 extending from second end flange 242 toward second bulkhead 260. Second tubular part 244 extends from second end flange 242 to a single end opening 246 that provides the combined coolant flow to outlet 232.

Circular, ring-shapes seals 247 can be provided around second tubular part 244 to sealingly engage an inner surface of second tubular portion 264 to provide a sealed engagement and prevent coolant leakage. Second tubular part 244 can be axially adjusted within second tubular portion 264 to adjust the length of second connector assembly 230 and ease assembly of manifold 102 with the enclosure 60.

Combiner 234 includes a partition 238 that separates first outlet channel 236 and second outlet channel 240. Partition 238 includes a tapered and/or rounded nose 248 facing outlet 232 to combine the coolant flow received from respective ones of the first and second outlet channels 236, 240. The tapered and/or rounded configuration of nose 248 can reduce turbulence in the combined coolant flow and assist delivering to the combined coolant flow from first and second flow paths 106, 110 of first and second heat sinks 104, 108 to outlet 232 and coolant line 28.

Second end flange 242 includes a plurality of fastener holes 250 to receive corresponding ones of the fasteners 152. Fasteners 152 fasten combiner 234 to first outlet end 114 of first heat sink 104 and to second outlet end 118 of second heat sink 108. In an embodiment, first outlet end 114 and second outlet end 118 include outwardly projecting tabs 120 to receive the fasteners 152 to engage combiner 234 to each of the first and second heat sinks 104, 108. When fastened to heat sinks 104, 108, first outlet channel 236 is aligned with first flow path 106 of first heat sink 104, and second outlet channel 240 is aligned with second flow path 110 of second heat sink 108.

Second connector assembly 230 also includes at least one outlet end seal between second end flange 242 and the first and second outlet ends 114, 118 of the first and second heat sinks 104, 108. In an embodiment, a first outlet end seal 254 is sealingly engaged between second end flange 242 of combiner 234 and first outlet end 114 of first heat sink 104. First outlet end seal 254 extends around first flow path 106 of first heat sink 104 at first outlet end 114 and around first outlet channel 236 of second end flange 242. A second outlet end seal 256 is sealingly engaged between second end flange 242 of combiner 234 and second outlet end 118 of second heat sink 108. Second outlet end seal 256 extends around second flow path 110 of second heat sink 108 at second outlet end 118 and around second outlet channel 240 of second end flange 242. In the illustrated embodiments, first and second outlet end seals 254, 256 are rectangular to match the shapes of first and second flow paths 106, 110 and/or first and second outlet channels 236, 240, but other shapes are also contemplated.

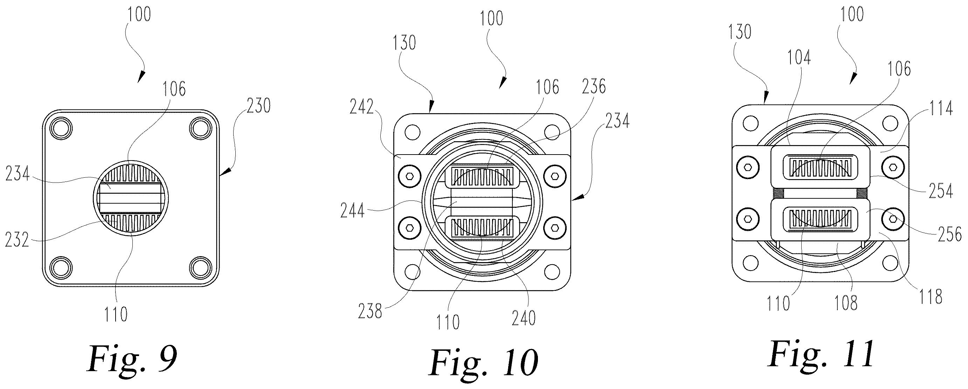

FIG. 9 is an end view looking toward second connector assembly 230. An end view looking toward first connector assembly 130 would be similar. First and second flow paths 106, 110 of first and second heat sinks 104, 108 are shown in fluid communication with outlet 232. Combiner 234 is also visible upstream of outlet 232.

FIG. 10 is the view of FIG. 9 with bulkhead 260 and second seal 270 removed. Combiner 234 is shown mounted to first and second heat sink 104, 108, and first connector assembly 130 is visible in the background. First and second outlet channels 236, 240 are shown aligned with first and second flow paths 106, 110, respectively, to receive coolant flow therefrom. FIG. 11 is the view of FIG. 10 but with combiner 234 removed. Outlet end seals 254, 256 are shown mounted to first and second outlet ends 114, 118 of first and second heat sinks 104, 108, respectively.

First and second heat sinks 104, 108 are engaged to first and second connector assemblies 130, 230 so that a space 122 is provided between first and second heat sinks 104, 108. Power electronics 50 are positioned in space 122 so that opposite sides of the power electronics 50 simultaneously receive cooling from the coolant flow through first and second coolant flow paths 106, 110 of first and second heat sinks 104, 108. In addition, a plurality of fasteners 124 can secure first and second heat sinks 104, 108 to one another with power electronics 50 therebetween to maintain the positioning of heat sinks 104, 108 relative to one another and relative to power electronics 50.

In an embodiment, first and second heat sinks 104, 108 each include a rectangular body that defines the respective flow channels 106, 110 therethrough. Other shapes and configurations for first and second heat sinks 104, 108 are also contemplated and not precluded. The flow channels 106, 110 may be rectangular in shape as shown, but other shapes, including circular, oval, and other non-circular and non-rectangular shapes are contemplated. First and second heat sinks 104, 108 may include fins or other structures and/or shapes along first and second flow paths 106, 110 to facilitate cooling of power electronics 50.

In an embodiment, first and second connector assemblies 130, 230 are configured similar to one another such that either of the first and second connector assemblies 130, 230 can serve as the inlet connector assembly, and the other could serve as the outlet connector assembly. However, embodiments in which one or more of first and second connector assemblies 130, 230 is optimized or designed differently from one another is also contemplated.

According to one aspect of the present disclosure, a cooling system for power electronics is provided. The cooling system includes at least one coolant line for circulating a coolant for cooling the power electronics, at least one enclosure housing the power electronics, and a manifold engaged to the at least one enclosure and to the at least one coolant line. The manifold provides a first flow path and a second flow path for the coolant along opposite sides of the power electronics housed in the at least one enclosure. The manifold includes a first connector assembly mounted to a first side of the at least one enclosure and a second connector assembly mounted to a second side of the at least one enclosure. The first connector assembly includes an inlet fluidly connected to receive the coolant from the at least one coolant line. The first connector assembly also includes a splitter connected to the first flow path and to the second flow path within the at least one enclosure. The splitter is configured to split the coolant received by the inlet and direct the split coolant into the first flow path and the second flow path. The second connector assembly is configured to combine the coolant received from the first flow path and from the second flow path. The second connector assembly includes an outlet fluidly connected to the at least one coolant line.

In an embodiment, the manifold includes a first heat sink defining the first flow path and a second heat sink defining the second flow path. The first heat sink is connected to the second heat sink with the power electronics positioned between the first and second heat sinks.

In a further embodiment, a first inlet end seal is engaged between the splitter and the first heat sink. The first inlet end seal extends around the first flow path. A second inlet end seal is engaged between the splitter and the second heat sink. The second inlet end seal extends around the second flow path.

In a further embodiment, the splitter includes an end flange connected to each of the first heat sink and the second heat sink.

In an embodiment, the splitter includes an inlet end including a single end opening for receiving the coolant from the inlet and an outlet end opposite the inlet end. The outlet end includes a partition separating the splitter into a first inlet channel and a second inlet channel. The first inlet channel is aligned with the first flow path and the second inlet channel is aligned with the second flow path.

In a further embodiment, the partition is tapered from the first and second inlet channels toward the single end opening.

In an embodiment, the manifold includes a bulkhead mounted to the first side of the at least one enclosure. The bulkhead is connected to the coolant line. The bulkhead defines the inlet for receiving the coolant flow from the coolant line. The bulkhead is further coupled to the splitter.

In a further embodiment, the bulkhead includes a tubular portion that extends through the first side of the at least one enclosure. The tubular portion receives a part of the splitter therein. The bulkhead also includes a mounting flange at an end of the tubular portion opposite the splitter. The mounting flange is located outside of and fastened to the first side of the at least one enclosure.

In a further embodiment, one or more seals are provided that extend circumferentially around the splitter that are located between the splitter and the tubular portion.

In a further embodiment, a face seal is provided between the mounting flange of the bulkhead and the first side of the at least one enclosure.

In an embodiment, the power electronics include semiconductor devices.

According to another aspect of the present disclosure, an apparatus for cooling power electronics is provided. The apparatus includes a first heat sink defining a first flow path for a coolant and a second heat sink defining a second flow path for coolant. The first flow path extends from a first inlet end to a first outlet end of the first heat sink, and the second flow path extending from a second inlet end to a second outlet end of the second heat sink. The second heat sink is spaced from the first heat sink in order to receive power electronics therebetween. The apparatus also includes a first connector assembly connected to the first inlet end of the first heat sink and the second inlet end of the second heat sink. The first connector assembly includes an inlet for receiving the coolant, a first inlet channel aligned with the first flow path of the first heat sink to fluidly connects the inlet to the first flow path, and a second inlet channel separated from the first flow channel. The second inlet channel is aligned with the second flow path of the second heat sink to fluidly connect the inlet to the second flow path. The apparatus also includes a second connector assembly connected to the first outlet end of the first heat sink and the second outlet end of the second heat sink. The second connector assembly includes a first outlet channel aligned with the first flow path of the first heat sink to receive the coolant from the first flow path and a second outlet channel separated from the first outlet channel. The second outlet channel is aligned with the second flow path of the second heat sink to receive the coolant from the second flow path. The second connector assembly also includes an outlet for receiving the coolant from the first outlet channel and the second outlet channel.

In an embodiment, the first connector assembly includes a first end flange fastened to the first inlet end of the first heat sink and fastened to the second inlet end of the second heat sink. The second connector assembly includes a second end flange fastened to the first outlet end of the first heat sink and fastened to the second outlet end of the second heat sink.

In a further embodiment, the first connector assembly includes at least one inlet end seal between the first end flange and the first and second inlet ends of the first and second heat sinks. The second connector assembly includes at least one outlet end seal between the second end flange and the first and second outlet ends of the first and second heat sinks.

In an embodiment, the first connector assembly includes a first splitter connected to the first inlet end of the first heat sink and the second inlet end of the second heat sink. The first splitter defines the first inlet channel and the second inlet channel. The second connector assembly includes a second splitter connected to the first outlet end of the first heat sink and the second outlet end of the second heat sink. The second splitter defines the first outlet channel and the second outlet channel.

In a further embodiment, the first connector assembly includes a first bulkhead mounted to the first splitter. The first bulkhead defines the inlet. The second connector assembly includes a second bulkhead mounted to the second splitter. The second bulkhead defines the outlet.

In a further embodiment, the first bulkhead includes a first tubular portion that telescopingly receives a first tubular part of the first splitter. The second bulkhead includes a second tubular portion that telescopingly receives a second tubular part of the second splitter therein.

In a further embodiment, at least one first annular seal is provided around the first tubular part of the first splitter that sealingly engages the first tubular portion. At least one second annular seal is provided around the second tubular part of the second splitter that sealingly engages the second tubular portion.

In an embodiment, the first connector assembly includes a first mounting flange around the inlet. The first mounting flange is for mounting the first connector assembly to a first sidewall of an enclosure for the power electronics. The second connector assembly includes a second mounting flange around the outlet. The second mounting flange is for mounting the second connector assembly to a second sidewall of the enclosure opposite of the first sidewall.

In an embodiment, the inlet includes an upstream inlet portion configured for connection with a coolant line and a downstream inlet portion for receiving the coolant from the coolant line. The outlet includes a downstream outlet portion configured for connection with the coolant line and an upstream outlet portion for receiving the coolant from the first and second flow paths and providing the coolant to the coolant line.

While illustrative embodiments of the disclosure have been illustrated and described in detail in the drawings and foregoing description, the same is to be considered as illustrative and not restrictive in character, it being understood that only certain exemplary embodiments have been shown and described and that all changes and modifications that come within the spirit of the claimed inventions are desired to be protected. It should be understood that while the use of words such as preferable, preferably, preferred or more preferred utilized in the description above indicate that the feature so described may be more desirable, it nonetheless may not be necessary and embodiments lacking the same may be contemplated as within the scope of the invention, the scope being defined by the claims that follow. In reading the claims, it is intended that when words such as "a," "an," "at least one," or "at least one portion" are used there is no intention to limit the claim to only one item unless specifically stated to the contrary in the claim. When the language "at least a portion" and/or "a portion" is used the item can include a portion and/or the entire item unless specifically stated to the contrary. Non-limiting examples of what may be claimed in one or more non-provisional applications claiming priority to the present application include the following.

## Claims

1. A cooling system for power electronics, the cooling system comprising:
at least one coolant line for circulating a coolant for cooling the power electronics;
at least one enclosure housing the power electronics; and
a manifold engaged to the at least one enclosure and to the at least one coolant line, the manifold providing a first flow path and a second flow path for the coolant along opposite sides of the power electronics housed in the at least one enclosure, the manifold including:
a first connector assembly mounted to a first side of the at least one enclosure, the first connector assembly including an inlet fluidly connected to receive the coolant from the at least one coolant line, the first connector assembly including a splitter connected to the first flow path and to the second flow path within the at least one enclosure, the splitter configured to split the coolant received by the inlet and direct the split coolant into the first flow path and the second flow path; and
a second connector assembly mounted to a second side of the at least one enclosure, the second connector assembly being configured to combine the coolant received from the first flow path and from the second flow path, the second connector assembly including an outlet fluidly connected to the at least one coolant line.

2. The cooling system of claim 1, wherein:
(a) the manifold further comprises:
a first heat sink defining the first flow path; and
a second heat sink defining the second flow path, wherein the first heat sink is connected to the second heat sink with the power electronics positioned between the first and second heat sinks, and/or
(b) wherein the power electronics include semiconductor devices.

3. The cooling system of claim 2,
(a) further comprising a first inlet end seal engaged between the splitter and the first heat sink, the first inlet end seal extending around the first flow path; and
a second inlet end seal engaged between the splitter and the second heat sink, the second inlet end seal extending around the second flow path, or
(b) wherein the splitter includes an end flange connected to each of the first heat sink and the second heat sink.

4. The cooling system of claim 1, wherein the splitter includes:
an inlet end including a single end opening for receiving the coolant from the inlet; and
an outlet end opposite the inlet end, the outlet end including a partition separating the splitter into a first inlet channel and a second inlet channel, wherein the first inlet channel is aligned with the first flow path and the second inlet channel is aligned with the second flow path.

5. The cooling system of claim 4, wherein the partition is tapered from the first and second inlet channels toward the single end opening.

6. The cooling system of claim 1, wherein the manifold further comprises:
a bulkhead mounted to the first side of the at least one enclosure, the bulkhead connected to the coolant line, the bulkhead defining the inlet for receiving the coolant flow from the coolant line, the bulkhead further being coupled to the splitter.

7. The cooling system of claim 6, wherein the bulkhead includes:
a tubular portion that extends through the first side of the at least one enclosure, wherein the tubular portion receives a part of the splitter therein; and
a mounting flange at an end of the tubular portion opposite the splitter, the mounting flange being located outside of and fastened to the first side of the at least one enclosure.

8. The cooling system of claim 7, further comprising {
(a) one or more seals extending circumferentially around the splitter that are located between the splitter and the tubular portion, or
(b) a face seal between the mounting flange of the bulkhead and the first side of the at least one enclosure.

9. An apparatus for cooling power electronics, the apparatus comprising:
a first heat sink defining a first flow path for a coolant, the first flow path extending from a first inlet end to a first outlet end of the first heat sink;
a second heat sink defining a second flow path for the coolant, the second flow path extending from a second inlet end to a second outlet end of the second heat sink, the second heat sink spaced from the first heat sink in order to receive power electronics therebetween;
a first connector assembly connected to the first inlet end of the first heat sink and the second inlet end of the second heat sink, the first connector assembly including:
an inlet for receiving the coolant;
a first inlet channel aligned with the first flow path of the first heat sink to fluidly connects the inlet to the first flow path; and
a second inlet channel separated from the first flow channel, the second inlet channel aligned with the second flow path of the second heat sink to fluidly connect the inlet to the second flow path; and
a second connector assembly connected to the first outlet end of the first heat sink and the second outlet end of the second heat sink, the second connector assembly including:
a first outlet channel aligned with the first flow path of the first heat sink to receive the coolant from the first flow path;
a second outlet channel separated from the first outlet channel, the second outlet channel aligned with the second flow path of the second heat sink to receive the coolant from the second flow path; and
an outlet for receiving the coolant from the first outlet channel and the second outlet channel.

10. The apparatus of claim 9, wherein:
the first connector assembly includes a first end flange fastened to the first inlet end of the first heat sink and fastened to the second inlet end of the second heat sink; and
the second connector assembly includes a second end flange fastened to the first outlet end of the first heat sink and fastened to the second outlet end of the second heat sink.

11. The apparatus of claim 10, further comprising:
at least one inlet end seal between the first end flange and the first and second inlet ends of the first and second heat sinks; and
at least one outlet end seal between the second end flange and the first and second outlet ends of the first and second heat sinks.

12. The apparatus of claim 9, wherein:
the first connector assembly includes a first splitter connected to the first inlet end of the first heat sink and the second inlet end of the second heat sink, the first splitter defining the first inlet channel and the second inlet channel; and
the second connector assembly includes a second splitter connected to the first outlet end of the first heat sink and the second outlet end of the second heat sink, the second splitter defining the first outlet channel and the second outlet channel.

13. The apparatus of claim 12, wherein:
the first connector assembly includes a first bulkhead mounted to the first splitter, the first bulkhead defining the inlet; and
the second connector assembly includes a second bulkhead mounted to the second splitter, the second bulkhead defining the outlet.

14. The apparatus of claim 13, wherein:
the first bulkhead includes a first tubular portion that telescopingly receives a first tubular part of the first splitter; and
the second bulkhead includes a second tubular portion that telescopingly receives a second tubular part of the second splitter therein, and optionally further comprising:
at least one first annular seal around the first tubular part of the first splitter that sealingly engages the first tubular portion; and
at least one second annular seal around the second tubular part of the second splitter that sealingly engages the second tubular portion.

15. The apparatus of claim 9, wherein:
(a) the first connector assembly includes a first mounting flange around the inlet, the first mounting flange for mounting the first connector assembly to a first sidewall of an enclosure for the power electronics; and
the second connector assembly includes a second mounting flange around the outlet, the second mounting flange for mounting the second connector assembly to a second sidewall of the enclosure opposite of the first sidewall, or
(b) the inlet includes an upstream inlet portion configured for connection with a coolant line and a downstream inlet portion for receiving the coolant from the coolant line; and
the outlet includes a downstream outlet portion configured for connection with the coolant line and an upstream outlet portion for receiving coolant from the first and second flow paths and providing the coolant to the coolant line.
